(19) Europäisches Patentamt
European Patent Office
Office européen des brevets

(11) **EP 3 157 067 B1**

(12) **FASCICULE DE BREVET EUROPEEN**

(45) Date de publication et mention
de la délivrance du brevet:
**15.07.2020 Bulletin 2020/29**

(51) Int Cl.:
*H01L 31/101* *(2006.01)*    *H01L 31/103* *(2006.01)*
*H01L 31/18* *(2006.01)*    *H01L 27/146* *(2006.01)*

(21) Numéro de dépôt: **16192974.0**

(22) Date de dépôt: **10.10.2016**

(54) **FABRICATION D'UNE MATRICE DE PHOTODIODES MULTISPECTRALE EN CDHGTE PAR DIFFUSION DE CADMIUM**

HERSTELLUNG EINER MATRIX VON MULTISPEKTRALEN HGCDTE-FOTODIODEN DURCH DIFFUSION VON CADMIUM

MANUFACTURING OF A CDHGTE MULTISPECTRAL PHOTODIODE ARRAY THROUGH CADMIUM DIFFUSION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.10.2015 FR 1502136**

(43) Date de publication de la demande:
**19.04.2017 Bulletin 2017/16**

(73) Titulaire: **Commissariat à l'Energie Atomique et aux Energies Alternatives**
**75015 Paris (FR)**

(72) Inventeur: **Rochette, Florent**
**38440 SAINT-JEAN DE BOURNAY (FR)**

(74) Mandataire: **Brevalex**
**56, Boulevard de l'Embouchure**
**B.P. 27519**
**31075 Toulouse Cedex 2 (FR)**

(56) Documents cités:
EP-A1- 0 069 453    EP-A1- 2 937 902
EP-A1- 2 975 643    US-A- 3 638 026
US-A- 5 861 626    US-A- 5 880 510
US-A1- 2014 319 580    US-A1- 2014 346 539

- ROGALSKI A ET AL: "Third-generation infrared photodetector arrays", JOURNAL OF APPLIED PHYSICS, AMERICAN INSTITUTE OF PHYSICS, US, vol. 105, no. 9, 11 mai 2009 (2009-05-11), pages 91101-91101, XP012125067, ISSN: 0021-8979, DOI: 10.1063/1.3099572
- ROGALSKI A: "HgCdTe infrared detector material: history, status and outlook; HgCdTe infrared detector material", REPORTS ON PROGRESS IN PHYSICS, INSTITUTE OF PHYSICS PUBLISHING, BRISTOL, GB, vol. 68, no. 10, 22 août 2005 (2005-08-22) , pages 2267-2336, XP020084623, ISSN: 0034-4885, DOI: 10.1088/0034-4885/68/10/R01

## Description

## DOMAINE TECHNIQUE

L'invention concerne le domaine des photodiodes infrarouges en CdHgTe, utilisées pour détecter un rayonnement infrarouge, notamment pour des applications en imagerie infrarouge. Elle concerne plus particulièrement un procédé de fabrication d'une matrice de photodiodes multi-spectrale.

## ÉTAT DE LA TECHNIQUE ANTÉRIEURE

Une matrice de photodiodes est dite multi-spectrale, lorsqu'elle présente une longueur d'onde de coupure qui varie dans le temps ou dans l'espace.

La longueur d'onde de coupure est la longueur d'onde au-dessus de laquelle un rayonnement n'est plus détecté par la photodiode.

La longueur d'onde de coupure d'une photodiode en CdHgTe dépend de la concentration en cadmium.

Le document EP 2 432 033 A2, décrit deux modes de réalisation d'une matrice de photodiodes bi-spectrale en alliage de cadmium, mercure et tellure de type $Cd_xHg_{1-x}Te$.

Dans un premier cas illustré en figure 6 de ce document, la matrice comprend des doublets de deux photodiodes montées tête-bêche, séparées par une couche barrière.

Un inconvénient de ce mode de réalisation est qu'il ne permet pas d'obtenir une cohérence temporelle de la détection bi-spectrale.

Un deuxième inconvénient est que la détection est limitée à du bi-spectral.

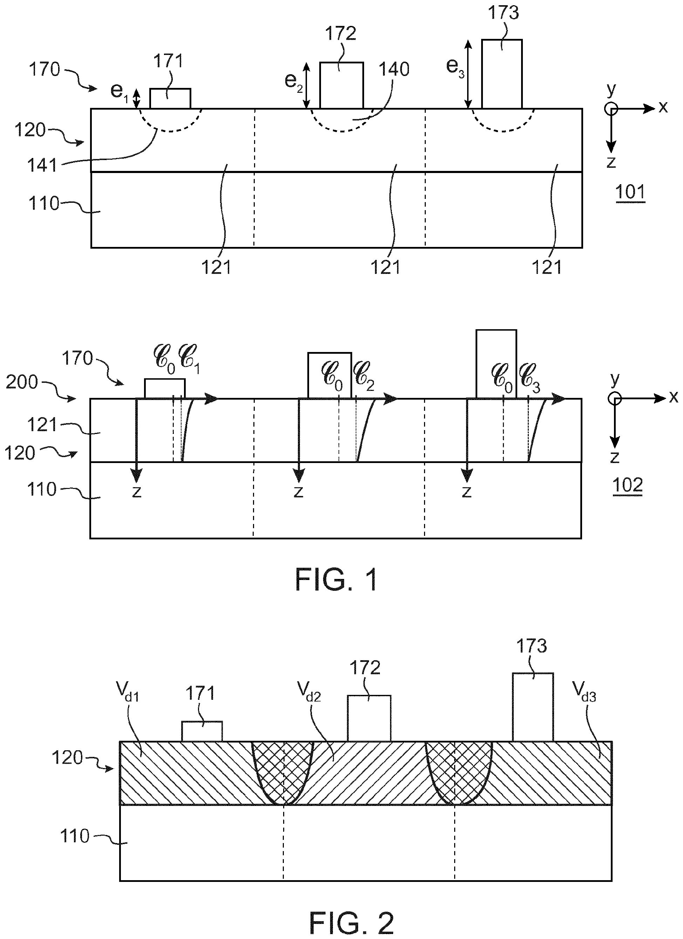

Dans un second cas illustré en figure 2, la matrice comprend une couche en $Cd_xHg_{1-x}Te$ et une couche en $Cd_yHg_{1-y}Te$, situées l'une au-dessus de l'autre et séparées par une couche barrière. Des tranchées découvrent localement la couche inférieure en $Cd_yHg_{1-y}Te$, ce qui permet de réaliser des jonctions PN dans chacune de ces deux couches.

Un premier inconvénient, que l'on retrouve également dans le premier mode de réalisation, est que la gravure des tranchées crée des défauts de matériau aux interfaces gravées. Ces défauts sont à l'origine d'un courant d'obscurité ainsi qu'un niveau de bruit additionnel pour le détecteur.

Un deuxième inconvénient, que l'on retrouve également dans le premier mode de réalisation, est que plusieurs croissances de couches cristallines de haute qualité et de composition variable sont nécessaires. Il est notamment nécessaire d'utiliser une croissance par épitaxie par jet moléculaire (EJM), ce type de croissance étant plus complexe qu'une croissance par épitaxie en phase liquide (EPL).

On connaît également le document US 2014/319580, qui concerne une matrice de photodiodes en HgCdTe, et qui propose une solution pour positionner avec précision une zone dopée relativement à une région fort gap de ladite matrice.

Dans le document US 5 861 626, il est décrit un procédé pour obtenir une matrice de photodiodes multi-spectrale, par diffusion de cadmium depuis une couche réservoir et chauffage contrôlé.

Dans le document US 3 638 026, il est décrit une matrice de photodiodes multi-spectrale présentant un gradient latéral de cadmium.

Le document US 5 880 510 décrit une matrice de photodiodes mésa, comportant en surface un gradient de cadmium.

Le document US 2014/346539 décrit une matrice de photodiodes, avec des lignes conductrices enterrées s'étendant entre les photodiodes.

Le document EP 0 069 453 décrit une couche semi-conductrice en $Cd_xHg_{1-x}Te$ surmontée d'une couche pleine de CdTe, et l'obtention d'un photo-détecteur bi-spectral par des irradiations sélectives à différentes longueurs d'onde.

Le document EP 2 975 643 a été publié après la date de priorité de la présente demande. Il décrit une matrice planaire, dans laquelle les photodiodes sont délimitées à l'aide de régions de séparation, riches en cadmium.

Le document EP 2 937 902 a été publié après la date de priorité de la présente demande. Il décrit une matrice planaire, dans laquelle la fonction de transfert de modulation est améliorée grâce à des régions riches en cadmium, entre les zones dopées.

Un objectif de la présente invention est de proposer une matrice de photodiodes multi-spectrale et un procédé de fabrication associé, ne présentant pas l'un au moins des inconvénients de l'art antérieur.

Un premier objectif de la présente invention est de proposer un procédé de fabrication compatible avec des techniques de croissance par EPL en plus des techniques EJM.

Un deuxième objectif de la présente invention est de proposer un procédé de fabrication d'une matrice de photodiodes multi-spectrale de type CdHgTe qui présente un courant d'obscurité et un niveau de bruit réduits.

Un troisième objectif de la présente invention est de proposer un procédé de fabrication d'une matrice de photodiodes de type CdHgTe offrant une détection multi-spectrale, non limité à du bi-spectral.

## EXPOSÉ DE L'INVENTION

Cet objectif est atteint avec un procédé, telle que définie dans la revendication 1, pour fabriquer une matrice de photodiodes multi-spectrale dans une couche semi-conductrice en $Cd_xHg_{1-x}Te$ constituée de régions juxtaposées dites pixels, le procédé comprenant une étape de réalisation d'une jonction PN dans chaque pixel.

Le procédé selon l'invention comprend les étapes suivantes, mises en œuvre au moins une fois :

- dépôt de matériau riche en cadmium sur la couche semi-conductrice en $Cd_xHg_{1-x}Te$, le matériau riche en cadmium présentant une concentration en cadmium supérieure celle de la couche semi-conductrice ; puis
- recuit d'inter-diffusion, réalisant la diffusion des atomes de cadmium depuis le matériau riche en cadmium vers la couche semi-conductrice ;

l'au moins une étape de dépôt de matériau riche en cadmium formant une étape de réalisation d'une structure riche en cadmium, la structure riche en cadmium étant structurée de façon à ce que tous les pixels de la couche semi-conductrice ne soient pas surmontés d'une même quantité d'atomes de cadmium, cette quantité pouvant être nulle ; et

l'au moins un recuit d'inter-diffusion étant adapté pour qu'à l'issue de cet au moins un recuit, tous les pixels ne présentent pas la même longueur d'onde de coupure.

En d'autres termes, on peut considérer que le procédé selon l'invention comprend les étapes suivantes :

- réalisation d'une structure riche en cadmium sur la couche semi-conductrice en $Cd_xHg_{1-x}Te$, structurée de façon à ce que tous les pixels ne soient pas surmontés d'une même quantité d'atomes de cadmium, cette quantité pouvant être nulle ; et
- recuit d'inter-diffusion, réalisant la diffusion des atomes de cadmium depuis la structure riche en cadmium vers la couche semi-conductrice, de sorte qu'à l'issue du recuit tous les pixels ne présentent pas la même longueur d'onde de coupure.

En particulier, la couche semi-conductrice peut être structurée de façon à ce que des pixels soient surmontés de portions respectives de la structure riche en cadmium, présentant différents volumes (un volume étant défini par une épaisseur et une section de ladite portion) et/ou concentrations initiales, le volume pouvant être nul.

La concentration est dite initiale, pour désigner la concentration préalablement au recuit d'inter-diffusion. Il s'agit d'une concentration volumique.

Un pixel peut être surmonté d'une quantité nulle d'atomes de cadmium. En d'autres termes, un pixel peut ne pas être surmonté par une portion de structure riche en cadmium.

A l'issue du recuit, les atomes de cadmium de la structure riche en cadmium ont migré totalement ou en partie dans la couche semi-conductrice située en dessous, modifiant localement la concentration en cadmium dans celle-ci. La quantité d'atomes de cadmium surmontant un pixel avant le recuit diffère, d'un pixel à l'autre. Par conséquent, la quantité d'atomes de cadmium ayant migré dans un pixel à l'issue du recuit diffère, d'un pixel à l'autre. Ainsi, tous les pixels ne présentent pas la même longueur d'onde de coupure. On réalise ainsi une matrice de photodiodes multi-spectrale, puisqu'à chaque pixel correspond une photodiode.

Le procédé selon l'invention n'impose pas d'étape de gravure. On s'affranchit ainsi des conséquences négatives de cette gravure sur les performances électro-optiques du détecteur réalisé. On peut réaliser en particulier une matrice de photodiodes qui ne présente pas le courant d'obscurité et l'excès de bruit provoqués par une étape de gravure, c'est-à-dire une matrice de photodiodes qui présente un courant d'obscurité et un niveau de bruit réduits.

Les performances électro-optiques sont également améliorées et le procédé de fabrication simplifié du fait que l'on part d'une unique couche semi-conductrice (une seule croissance de couche).

Les différentes photodiodes ne sont pas superposées les unes sur les autres, et peuvent donc détecter chacune un rayonnement infrarouge simultanément. On réalise donc un détecteur multi-spectral à cohérence temporelle.

L'invention n'est pas limitée à du bi-spectral, et l'on peut facilement réaliser des détecteurs à plus que deux longueurs d'onde de coupure différentes, à l'aide d'une pluralité de dimensions possibles pour les portions de structure riche en cadmium.

Enfin, le procédé n'impose pas une croissance cristalline de couche CdHgTe par EJM, puisqu'il ne met en œuvre qu'une seule couche semi-conductrice CdHgTe. Une croissance cristalline de couche HgCdTe par EPL est possible, avec *in fine* un gain attendu sur le coût de fabrication de la matrice de photodiodes.

Selon un premier mode de réalisation, la structure riche en cadmium est constituée de portions, centrées chacune sur un pixel de la couche semi-conductrice.

Chaque portion peut présenter une forme de plot, plein au centre et espacé des autres plots.

En variante, chaque portion peut présenter une forme de plot, ouvert au centre et espacé des autres plots.

Selon une autre variante, les différentes portions peuvent former ensemble une grille présentant des ouvertures centrées chacune sur un pixel.

Selon un deuxième mode de réalisation, la structure riche en cadmium est constituée de portions surmontant chacune un pixel de la couche semi-conductrice, chaque portion étant décentrée relativement au pixel correspondant et plusieurs portions étant formées d'un seul tenant.

La structure riche en cadmium présente avantageusement des portions de différentes épaisseurs.

En complément ou en variante, la structure riche en cadmium peut présenter des portions de différentes sections.

En complément ou en variante, la structure riche en cadmium peut présenter des portions de différentes concentrations initiales.

De préférence, la structure riche en cadmium est constituée de portions surmontant chacune un pixel de la couche semi-conductrice, et comprend au moins deux types de portions qui diffèrent par leurs sections, épaisseurs et/ou concentrations initiales.

Avantageusement, la structure riche en cadmium est périodique, et un motif élémentaire de la structure périodique s'étend au-dessus d'une pluralité de pixels de la couche semi-conductrice.

Le procédé selon l'invention peut comprendre plusieurs cycles des étapes de matériau riche en cadmium sur la couche semi-conductrice, puis recuit d'inter-diffusion.

La couche semi-conductrice peut présenter une structure mésa dans laquelle des tranchées séparant des photodiodes voisines s'étendent sur toute la hauteur de ladite couche semi-conductrice, le procédé comprenant en outre une métallisation de ces tranchées, réalisant une liaison électrique entre les photodiodes.

En variante, la couche semi-conductrice présente une structure mésa dans laquelle des tranchées séparant des photodiodes voisines ne s'étendent pas sur toute la hauteur de ladite couche semi-conductrice, de façon à préserver la continuité électrique entre les photodiodes.

L'invention concerne également une matrice de photodiodes multi-spectrale obtenue par un procédé selon l'invention, dans laquelle la couche semi-conductrice est constituée d'au moins deux types de pixels qui diffèrent par leur longueur d'onde de coupure.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :

- la figure 1 illustre de manière schématique un premier mode de réalisation du procédé selon l'invention ;
- la figure 2 illustre de manière schématique la diffusion du cadmium dans le procédé représenté en figure 1 ;
- la figure 3 illustre de manière schématique une matrice de photodiodes obtenue à l'aide du procédé représenté en figure 1 ;
- la figure 4 illustre une variante du procédé et de la matrice de photodiodes illustrés aux figures 1 à 3 ;
- les figures 5A, 5B, et 6, illustrent deux variantes d'une structure riche en cadmium selon l'invention ;
- la figure 7 illustre de manière schématique un deuxième mode de réalisation du procédé et de la matrice de photodiodes selon l'invention ;
- la figure 8 illustre une variante du procédé et de la matrice de photodiodes illustrés à la figure 7 ;
- les figures 9A à 9E illustrent différentes variantes d'une structure riche en cadmium selon l'invention ; et

- Les figures 10A et 10B illustrent de manière schématique un troisième mode de réalisation du procédé selon l'invention ; et
- les figures 11A, 11B et 11C illustrent de manière schématique deux variantes des procédés et matrices de photodiodes illustrés aux figures 4 et 7.

## EXPOSÉ DÉTAILLÉ DE MODES DE RÉALISATION PARTICULIERS

Pour des raisons de lisibilité, les échelles ne sont pas forcément respectées sur les figures.

La figure 1 illustre un premier mode de réalisation d'un procédé selon l'invention.

Le procédé selon l'invention est destiné à la fabrication d'une matrice de photodiodes multi-spectrale, c'est-à-dire comprenant des photodiodes présentant différentes longueurs d'onde de coupure. Par exemple, les longueurs d'onde de coupure de deux photodiodes voisines diffèrent d'au moins 1% l'une relativement à l'autre, de préférence au moins 3%.

Dans ce mode de réalisation, on réalise une matrice de photodiodes planaire.

La figure 1 illustre une matrice de photodiodes selon l'invention, à différentes étapes de sa réalisation, et selon des vues en coupe selon le plan (xOz). L'axe (Oz) est parallèle à l'axe de la croissance des couches cristallines sur un substrat 110, orienté depuis ladite couche cristalline en direction du substrat. L'axe (Ox) est orthogonal à (Oz).

Au cours d'une étape préliminaire à la mise en œuvre de l'invention, on fait croître sur le substrat 110 une unique couche semi-conductrice 120 en matériau semi-conducteur de type $Cd_xHg_{1-x}Te$. Le substrat 110 est par exemple en CdZnTe, ou Si, ou AsGa, ou Ge. La croissance est réalisée de préférence par épitaxie en phase liquide, bien qu'une épitaxie par jet moléculaire soit également possible.

La composition de la couche semi-conductrice en $Cd_xHg_{1-x}Te$ est définie par x réel compris entre 0 et 1, les bornes étant exclues.

x est considéré comme initialement constant, au moins dans des plans orthogonaux à l'axe (Oz), et possiblement dans tout le volume de la couche semi-conductrice 120.

La couche semi-conductrice présente généralement une épaisseur comprise entre 100 nm et 30 $\mu$m, de préférence entre 100 nm et 3 $\mu$m.

La couche semi-conductrice 120 est constituée de pixels 121. Ces pixels sont des régions de la couche semi-conductrice 120. Ces pixels sont adjacents les uns aux autres. De préférence, ils présentent tous les mêmes dimensions. Sur la figure 1, les pixels 121 sont délimités par des traits mixtes verticaux. Ils présentent par exemple chacun une forme de parallélépipède rectangle.

Par souci de concision, la figure 1 n'illustre que trois pixels.

Chaque pixel 121 reçoit une jonction PN 141.

Chaque jonction PN 141 sépare un caisson 140 dopé N ou P, obtenu par implantation ou par diffusion d'impuretés dopantes, du restant de cette couche semi-conductrice, dopée P ou N. Le caisson est spécifique à la photodiode et avantageusement affleurant sur la face supérieure de la couche semi-conductrice 120. La face supérieure de la couche semi-conductrice est située du côté opposé au substrat 110.

La couche semi-conductrice 120 formera donc une couche semi-conductrice optiquement active.

Les caissons 140 sont réalisés avant, après ou pendant la mise en œuvre des étapes du procédé selon l'invention. Pour faciliter la compréhension de l'invention, ils sont cependant représentés en figure 1.

Dans une première étape 101 du procédé selon l'invention, on dépose un matériau riche en cadmium sur la couche semi-conductrice 120, ledit matériau riche en cadmium étant structuré pour former une structure riche en cadmium 170 sur la couche semi-conductrice 120.

En particulier, la structure riche en cadmium est déposée directement sur la couche semi-conductrice 120, en contact physique direct avec sa face supérieure, du côté opposé au substrat.

La structure 170 est dite riche en cadmium, car elle présente une concentration en cadmium supérieure à celle de la couche semi-conductrice 120.

En particulier, la concentration moyenne initiale en cadmium, dans le matériau riche en cadmium, est supérieure à la concentration moyenne initiale en cadmium, dans la couche semi-conductrice 120.

La structure riche en cadmium 170 est formée par exemple d'un matériau binaire, ternaire, ou quaternaire, voire plus. Ce matériau comprend avantageusement des éléments appartenant aux colonnes II et VI du tableau périodique des éléments. Il s'agit par exemple et de manière non limitative de CdS, CdSe, CdTe, CdZn-Se, CdMnSe, etc.

La structure riche en cadmium 170 est dite structurée, car elle comprend des ouvertures traversantes définissant plusieurs portions de ladite structure.

La structure riche en cadmium 170 est constituée de portions 171, 172, 173, surmontant chacune un pixel 121 de la couche semi-conductrice.

En d'autres termes, chaque portion 171, 172, 173 est déposée directement sur un pixel respectif, en contact physique direct avec sa face supérieure, du côté opposé au substrat. Chaque portion 171, 172, 173 ne recouvre que partiellement le pixel correspondant. Chaque portion 171, 172, 173 s'étend uniquement au-dessus du pixel correspondant, sans déborder au-dessus d'un pixel voisin.

Pour des raisons de lisibilité, sur la figure 1, l'épaisseur selon (Oz) de ces portions 171, 172, 173 est fortement exagérée.

Chaque portion 171, 172, 173 présente une épaisseur comprise entre 10 nm et 10 $\mu$m, par exemple entre 100 nm et 500 nm, de préférence moins de 300 nm.

Dans l'exemple illustré en figure 1, chaque pixel est surmonté d'une portion de la structure riche en cadmium. En variante, certains pixels ne sont surmontés par aucune portion de la structure riche en cadmium.

Les portions 171, 172, 173 ont ici des formes de plots, pleins au centre et centrés chacun sur un pixel 121, qui présentent tous la même concentration initiale en cadmium.

On définit le centre d'un pixel comme le centre du volume occupé par ce pixel.

Ces plots présentent ici différentes épaisseurs selon (Oz), et la même section dans un plan orthogonal à l'axe (Oz), parallèle à la face supérieure de la couche semi-conductrice 120. Le plot 171 présente une épaisseur $e_1$, le plot 172 une épaisseur $e_2$, et le plot 173 une épaisseur $e_3$, avec $e_1 < e_2 < e_3$. Ces plots peuvent présenter chacun une forme de cylindre de révolution. D'autres formes peuvent être utilisées, notamment des cylindres à base non circulaire, carré par exemple. La largeur des plots, fonction du pas pixel, peut par exemple être comprise entre 300 nm et 10 $\mu$m, pour un pas pixel de 15 $\mu$m. Chaque plot peut couvrir plus de 50% de la face supérieure d'un pixel 121.

On présentera dans la suite d'autres exemples de réalisation des portions de la structure riche en cadmium, telles des pixels soient surmontés d'une quantité différente d'atomes de cadmium, par exemple des portions de différentes sections ou de différentes concentrations initiales. On peut également mettre en œuvre toutes les combinaisons possibles d'épaisseur, section et concentration initiale, telle qu'au moins l'un de ces paramètres varie d'un pixel à l'autre. Des réalisations plus complexes peuvent également être mises en œuvre grâce à plusieurs étapes de dépôt de matériau riche en cadmium, la concentration initiale en cadmium et/ou la forme des plots déposés à chaque étape de dépôt pouvant varier.

La structure riche en cadmium peut présenter au moins deux types de portions qui diffèrent par leurs sections, épaisseurs et/ou concentrations initiales, de préférence au moins deux types. En variante, toutes les portions formant la structure riche en cadmium sont identiques, et certains pixels de la couche semi-conductrice ne sont recouverts par aucune portion de la structure riche en cadmium.

La structure riche en cadmium 170 peut être réalisée par une technique de photolithographie dite de lift-off. Pour cela, on dépose une couche de résine sur la couche semi-conductrice 120. Ensuite, on grave localement la résine, et on dépose un matériau riche en cadmium directement sur la résine. Là où la résine est développée, le matériau riche en cadmium est en contact direct avec la couche semi-conductrice 120, et forme lesdites portions 171, 172, 173. Là où la résine n'est pas développée, le matériau riche en cadmium s'étend sur la résine. On retire ensuite la résine. Le matériau riche en cadmium n'est conservé que là où il était en contact direct avec la couche semi-conductrice 120.

L'épaisseur de la couche de résine est supérieure ou égale à l'épaisseur souhaitée de la structure riche en cadmium 170. On peut mettre en œuvre plusieurs cycles de dépôt de résine, et dépôt de matériau riche en cadmium, notamment pour réaliser des plots de différentes épaisseurs. Des matériaux de concentration initiale en cadmium différente pourront être utilisés lors de dépôts successifs.

En variante, la structure riche en cadmium peut être réalisée par dépôt d'un matériau riche en cadmium directement sur la couche semi-conductrice 120, suivi d'une gravure locale pour ne conserver le matériau riche en cadmium qu'en certains emplacements. L'étape de gravure peut utiliser un masque en résine, déposé sur le matériau riche en cadmium. Le matériau riche en cadmium peut être gravé par gravure chimique à travers des ouvertures traversantes dans le masque en résine, par exemple à l'aide d'une solution de brome. Une gravure physique est également possible.

Là encore, on peut mettre en œuvre plusieurs cycles de dépôt de matériau riche en cadmium et gravure, le matériau riche en cadmium n'étant pas déposé toujours aux mêmes emplacements à chacun desdits cycles.

A l'étape 102, on effectue un recuit de l'ensemble formé par la couche semi-conductrice 120 et la structure riche en cadmium 170.

Ce recuit réalise une inter-diffusion des atomes de cadmium, entre les atomes de cadmium de chaque portion 171, 172, 173 de la structure riche en cadmium, et les atomes de mercure du pixel correspondant.

L'homme du métier saura adapter la température et la durée du recuit pour qu'à l'issue du recuit, les pixels présentent différentes concentrations minimales en cadmium.

Le recuit est réalisé de préférence à une température comprise entre 100°C et 500°C, pendant une durée comprise entre quelques minutes et plusieurs jours.

On sélectionne une température et/ou une durée du recuit d'autant plus élevées que la concentration initiale en cadmium dans la couche semi-conductrice 120 est importante.

En outre, la température et la durée du recuit augmentent avec l'épaisseur de la couche semi-conductrice 120.

De préférence, le recuit est réalisé sous pression de vapeur saturante de mercure. Le recuit peut être réalisé en une ou plusieurs fois. Le recuit peut également être réalisé sous vide. L'inter-diffusion sera alors plus lente (mécanisme limité par le déplacement des lacunes de mercure alors que sous pression de vapeur saturante de mercure, le mécanisme est dominé par la diffusion d'interstitiels, phénomène plus rapide).

La température et la durée du recuit peuvent également prendre en compte les étapes technologiques mises en œuvre pour fabriquer une matrice de photodiodes selon l'invention, de sorte que les pixels de la matrice de photodiodes finale présentent toujours différentes concentrations minimales en cadmium.

En outre, la structure riche en cadmium et le recuit sont adaptés de sorte que chaque portion de la structure riche en cadmium présente une épaisseur H, mesurée selon l'axe (Oz), telle que :

$$H < L_d, \text{ avec } L_d = \sqrt{D * t}$$

Avec $L_d$ la longueur de diffusion du cadmium dans la structure riche en cadmium 170, t la durée du recuit, et D le coefficient de diffusion du cadmium dans la structure riche en cadmium 170, qui dépend de la température du recuit et de la concentration en cadmium. Ce coefficient de diffusion évolue donc au cours du recuit dans la structure riche en cadmium 170 de même que dans la couche semi-conductrice 120, du fait de l'inter-diffusion.

Cette relation traduit le fait qu'il faut que chacun des plots riches cadmium ait une épaisseur inférieure à la longueur de diffusion des atomes de cadmium au sein de ces plots. Autrement dit, l'épaisseur de ces plots peut être définie comme une couche mince vis-à-vis de la longueur de diffusion du cadmium.

Par exemple, soit une couche semi-conductrice 120 en $Cd_xHg_{1-x}Te$ d'épaisseur 3 $\mu$m, avec initialement x=0,22, et la mise en œuvre d'une technologique de type P/N, i.e. la couche semi-conductrice 120 est dopée N, le recuit est réalisé à 300°C pendant 40 heures, sous pression de vapeur saturante de mercure, pour des structures riches en cadmium de dimensions circulaires 10$\mu$m dans le plan xOy et d'épaisseur 100, 200 et 300nm respectivement (selon Fig.1), pour des pixels au pas de 15$\mu$m.

Les conditions du recuit sont adaptées de sorte qu'à l'issue du recuit, les pixels ne présentent pas tous la même longueur d'onde de coupure.

On peut considérer que cette longueur d'onde de coupure est définie par la concentration minimale en cadmium dans le pixel.

Sur la figure 1, étape 102, on a représenté, pour chaque pixel et de façon schématique, en fonction de la profondeur z, la répartition à l'issue du recuit des atomes de cadmium provenant de la structure riche en cadmium. Afin d'alléger la figure, les caissons 140 ne sont pas illustrés à l'étape 102.

On considère qu'avant le recuit 102, les pixels présentent tous la même concentration initiale en cadmium $C_0$.

De façon schématique, chaque portion 171, 172, 173 forme un réservoir fini d'atomes de cadmium disponibles pour diffuser dans le pixel situé en-dessous. Lors du recuit, le cadmium de chaque portion 171, 172, 173 diffuse dans le pixel correspondant.

Après le recuit 102, le pixel situé sous la portion 171 de la structure riche en cadmium présente une concentration minimale $C_1$ associée à une longueur d'onde de coupure $\lambda_1$ le pixel situé sous la portion 172 présente une concentration minimale $C_2$ associée à une longueur d'onde de coupure $\lambda_2$, et le pixel situé sous la portion 173 présente une concentration minimale $C_3$ associée à une longueur d'onde de coupure $\lambda_3$, avec $C_1 < C_2 < C_3$.

La concentration en cadmium dans chaque pixel en fonction de la profondeur peut présenter une forme de type exponentielle décroissante, ou erreur complémentaire.

Selon une variante non représentée, l'un des pixels de la couche semi-conductrice n'est recouvert par aucune portion de la structure riche en cadmium, de sorte que l'étape de recuit ne modifie pas sa concentration minimale en cadmium et la longueur d'onde de coupure associée.

A l'issue du recuit, ce qui subsiste de la structure riche en cadmium peut être conservé ou retiré.

Lorsque les jonctions PN 141 sont réalisées avant réalisation de la structure riche en cadmium et recuit, on peut conserver ce qui subsiste de la structure riche en cadmium à l'issue du recuit.

De préférence, les jonctions PN sont réalisées après réalisation de la structure riche en cadmium et recuit. On préfère alors, avant l'implantation de dopant, retirer ce qui subsiste de la structure riche en cadmium à l'issue du recuit.

Préférentiellement, ces résidus de structures riches en cadmium seront retirés (pour conserver une meilleure planéité de la matrice le cas échéant).

On remarque que le procédé selon l'invention permet d'augmenter une concentration en cadmium moyenne au niveau de la face supérieure de la couche semi-conductrice 120, ce qui limite l'apparition de canaux de conduction entre les photodiodes. Il n'est donc pas nécessaire de supprimer ces canaux par d'autres moyens. Ces canaux de conductions dégradent la fidélité de l'image formée, après lecture de la matrice de photodiodes par un circuit de lecture. Cette augmentation de concentration en cadmium au niveau de la surface supérieure de la couche semi-conductrice 120 permet en outre de réduire l'apparition de défauts pixel en bruit basse fréquence de type 1/f, ce qui est bénéfique pour un fonctionnement du détecteur à de plus hautes températures.

Le premier mode de réalisation d'un procédé, tel qu'illustrés en figure 1, sera avantageusement utilisé pour la fabrication de matrices de photodiodes multispectrales de faible pas pixel, typiquement 15 μm et inférieur.

La figure 2 illustre de manière schématique la diffusion du cadmium les plots 171, 172, 173, dans le procédé représenté en figure 1.

Les atomes de cadmium de chaque plot 171, 172, 173, diffusent chacun dans un volume de diffusion respectif situé dans le pixel correspondant et pouvant s'étaler également sur des pixels voisins.

Dans l'exemple représenté en figure 2, chaque volume de diffusion $V_{d1}$, $V_{d2}$, $V_{d3}$ englobe un pixel et les bords des pixels adjacents.

Puisque chaque plot présente une épaisseur inférieure à la longueur de diffusion du cadmium dans ledit plot (condition $H < L_d$), la quantité d'atomes de cadmium provenant d'un plot de la structure riche en cadmium, et diffusant dans le volume de diffusion associé, augmente avec les dimensions de ladite portion. Dans l'exemple illustré ici, cette quantité augmente donc avec l'épaisseur des plots.

Ainsi, le volume $V_{d1}$ reçoit un nombre $N_1$ d'atomes de cadmium, le volume $V_{d2} = V_{d1}$ reçoit un nombre $N_2 > N_1$ d'atomes de cadmium, et le volume $V_{d3} = V_{d2}$ reçoit un nombre $N_3 > N_2$ d'atomes de cadmium. On obtient donc les différentes concentrations en cadmium $C_1$, $C_2$, $C_3$ décrites ci-dessus.

De préférence, les atomes de cadmium de chaque plot 171, 172, 173, diffusent sensiblement dans tout le volume du pixel correspondant (c'est-à-dire le pixel surmonté par ledit plot). En particulier, ils diffusent chacun dans un volume de diffusion englobant ledit pixel correspondant, et pouvant déborder sur des pixels voisins. Le rapport entre le volume de diffusion et le volume du pixel peut être compris entre 1 et 1,2.

En d'autres termes, le recuit est alors adapté pour que le cadmium d'une portion de la structure riche en cadmium diffuse sensiblement dans tout le volume du pixel situé en dessous.

Il n'est cependant pas nécessaire que le volume de diffusion soit supérieur ou égal au volume d'un pixel pour que la concentration minimale en cadmium varie d'un pixel à l'autre. En effet, il peut se produire une interdiffusion de cadmium lors de la croissance de la couche semi-conductrice 121 sur un substrat comprenant du cadmium, ce qui augmente la concentration en cadmium dans tout le fond de la couche semi-conductrice 121. Pour cette raison, la concentration en cadmium dans un pixel peut être minimale dans une zone du pixel, située à une profondeur $z < Z0$, avec $Z0$ l'épaisseur de la couche semi-conductrice 120, donc pas nécessairement à l'interface avec le substrat 110.

Selon un mode de réalisation avantageux, le volume de diffusion est égal au volume d'un pixel. En d'autres termes, le cadmium d'une portion de la structure riche en cadmium diffuse dans tout le volume du pixel situé en dessous sans déborder sur des pixels voisins.

Dans ce cas, l'épaisseur de la couche semi-conductrice 120 peut être sensiblement égale à la moitié d'une distance minimale entre deux portions voisines de la structure riche en cadmium (prises parmi tous les couples possibles).

La température et la durée du recuit sont en outre adaptées, de sorte que la longueur de diffusion latérale du cadmium soit égale à la longueur de diffusion en profondeur du cadmium et égale à l'épaisseur de la couche semi-conductrice 120.

En variante, la longueur de diffusion latérale du cadmium est égale à la moitié de la distance minimale entre deux portions voisines de la structure riche en cadmium, et l'épaisseur de la couche semi-conductrice 120 est inférieure à ladite moitié. On obtient toujours un volume de diffusion égal au volume d'un pixel, car en première approximation la diffusion du cadmium en profondeur est arrêtée à l'interface avec le substrat 110.

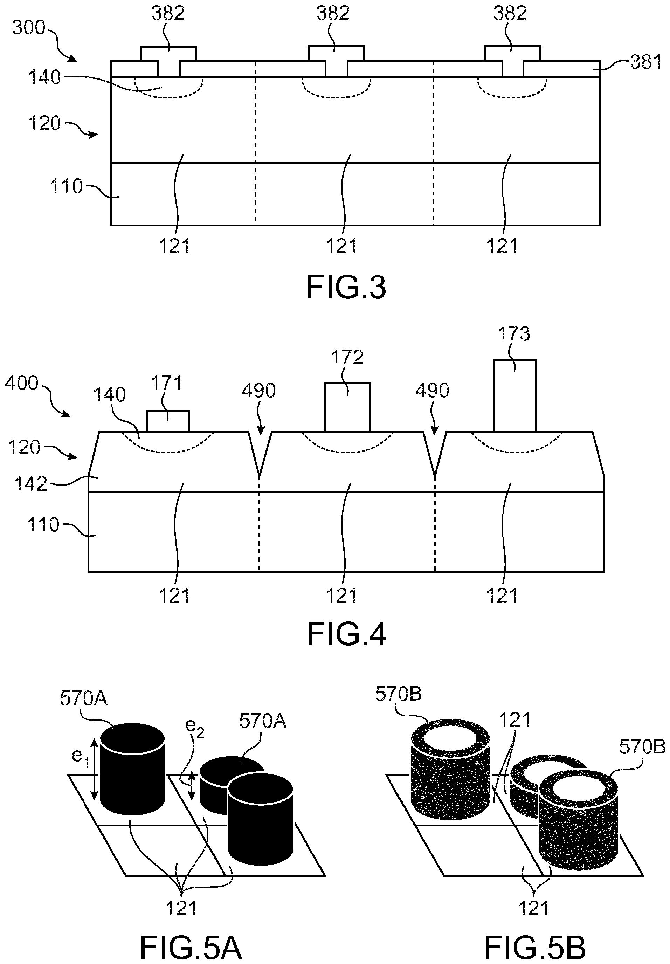

La figure 3 illustre de manière schématique une matrice de photodiodes 300, obtenue à l'aide du procédé représenté en figure 1.

Les plots 171, 172, 173 ont été retirés après l'étape de recuit d'inter-diffusion.

Des caissons 140 tels que mentionnés en référence à la figure 1 ont été réalisés après avoir retiré ces plots.

La dimension latérale des caissons 140 est avantageusement de l'ordre du pas pixel moins 4 à 5 $\mu$m, par exemple 11 $\mu$m pour un pas pixel de 15 $\mu$m. Cela permet d'améliorer la fonction de transfert de modulation du pixel. La jonction PN s'étend jusqu'à environ 1 $\mu$m sous la surface supérieure de la couche semi-conductrice 120.

La couche semi-conductrice 120 est recouverte par une couche de passivation 381, ouverte au-dessus de chaque caisson pour laisser passer un connecteur métallique 382.

La largeur d'un connecteur métallique 382 est avantageusement de l'ordre de grandeur de la largeur d'un caisson, voire légèrement inférieure de 1 à 2 $\mu$m, par exemple 10 $\mu$m pour un pas pixel de 15 $\mu$m. Cela permet d'améliorer le rendement quantique du pixel tout en évitant les inversions de surface entre la passivation et la couche semi-conductrice 120, propre à la présence de structure MIS (Métal-Isolant-Semiconducteur) dont la métallisation est polarisée en inverse dans le mode de fonctionnement normal de la photodiode.

Bien qu'il soit représenté à la figure 3, le substrat peut être retiré avant, pendant ou après la mise en œuvre des étapes du procédé selon l'invention.

Il existe dans la matrice 300 au moins deux photodiodes présentant chacune une longueur d'onde de coupure différence. La matrice 300 est donc multi-spectrale.

La différence entre leurs concentrations minimales en cadmium respectives est supérieure à 3% de la valeur maximale, voire 5%, et même 10%.

De préférence, les différents types de photodiodes, qui diffèrent par leur longueur d'onde de coupure, sont répartis régulièrement dans l'espace.

On peut notamment les répartir selon un agencement périodique des différents types de photodiodes, avec un motif élémentaire comprenant au moins une photodiode de chaque type.

Cela correspond à une structure riche en cadmium périodique, dont le motif élémentaire s'étend au-dessus d'une pluralité de pixels de la couche semi-conductrice et présente au moins une portion de chaque type (chaque portion surmontant un unique pixel, et les portions de chaque type se distinguant les unes des autres par leur volume et/ou leur concentration initiale). Un motif élémentaire de la structure périodique peut s'étendre au-dessus d'une pluralité de pixels de la couche semi-conductrice, parmi lesquels au moins un pixel n'est surmonté d'aucune portion de la structure riche en cadmium.

Les photodiodes de la matrice, respectivement les portions de la structure riche en cadmium, sont alors réparties en groupements de photodiodes, respectivement groupement de portions, chaque groupement correspondant à un motif élémentaire.

Par exemple, les différents types de photodiodes, respectivement les différents types de portions de la structure riche en cadmium, sont répartis selon une matrice de type Bayer.

Ainsi, tous les types de photodiodes ne sont pas forcément présents en même nombre, et la proportion de chaque type de photodiode permet de donner plus ou moins de poids à certaines gammes de longueur d'onde.

Les différents types de photodiodes diffèrent par leur longueur d'onde de coupure, chaque photodiode fournissant un signal large bande qui s'étend en première approximation de zéro (si le substrat a été retiré) à la longueur d'onde de coupure du pixel.

En fonctionnement, les signaux de toutes les photodiodes de la matrice sont lus en même temps.

Les signaux associés à des photodiodes d'un même groupement peuvent être combinés ensemble, par exemple pour les soustraire deux à deux, afin de disposer de signaux courte bande.

Par exemple, avec une matrice à trois types de photodiodes fournissant les signaux $S_0$, $S_1$ et $S_2$, de longueurs d'onde de coupure respectives $\lambda_0 > \lambda_1 > \lambda_2$, on réalise un détecteur bi-spectral à faible largeur de bande à l'aide des signaux $S_1$-$S_2$ et $S_0$-$S_1$.

En variante, avec une matrice à deux types de photodiodes fournissant les signaux $S_0$ et $S_1$, de longueurs d'onde de coupure respectives $\lambda_0 > \lambda_1$ on réalise un détecteur bi-spectral avec le signal large bande $S_1$ et le signal courte bande $S_0$-$S_1$.

Selon une autre variante, avec une matrice à trois types de photodiodes fournissant les signaux $S_0$, $S_1$ et $S_2$, de longueurs d'onde de coupure respectives $\lambda_0 > \lambda_1 > \lambda_2$, on réalise un détecteur tri-spectral à l'aide des signaux $S_2$, $S_1$-$S_2$ et $S_0$-$S_1$.

Selon une autre variante, avec une matrice à quatre types de photodiodes fournissant les signaux $S_0$, $S_1$, $S_2$ et $S_3$, de longueurs d'onde de coupure respectives $\lambda_0 > \lambda_1 > \lambda_2 > \lambda_3$, on réalise un détecteur tricolore courtes bandes à l'aide des signaux $S_2$-$S_3$, $S_1$-$S_2$ et $S_0$-$S_1$.

Le principe de ces variantes peut être étendu sans limite à des cas de détection multi-spectrale à encore plus de bandes selon les besoins du produit.

La figure 4 illustre une variante du procédé et de la matrice de photodiodes illustrés aux figures 1 à 3.

La matrice 400 illustrée en figure 4 diffère du mode de réalisation précédemment exposé en ce qu'elle ne présente pas une structure planaire, mais mésa.

La structure mésa préexiste à la mise en œuvre du procédé selon l'invention. Ce type de structure offre une meilleure qualité de la fonction de transfert de modulation.

Chaque photodiode présente une jonction PN entre un caisson 140 présentant un dopage P ou N, et une semelle 142 présentant un dopage de nature opposé N ou P.

Ici, les tranchées 490 séparant des photodiodes voisines ne s'étendent pas sur toute l'épaisseur de la couche semi-conductrice 120, afin d'offrir une continuité électrique entre les semelles des différentes photodiodes de la matrice. On peut ainsi polariser simultanément toutes les semelles des photodiodes, à l'aide d'une électrode déportée généralement en périphérie de la matrice.

Le rapport entre la profondeur des tranchées selon l'axe (Oz) et l'épaisseur maximale de la couche semi-conductrice 120 selon ce même axe est par exemple compris entre 0,8 et 0,9.

Cette variante permet d'obtenir très facilement des volumes de diffusion de chaque portion de la structure riche en cadmium, sensiblement égaux au volume d'un pixel de la couche semi-conductrice 120. En particulier, le volume de diffusion peut être compris entre 1 et 1,1 fois le volume du pixel.

La figure 4 illustre plus particulièrement la matrice obtenue directement à l'issue du recuit d'inter-diffusion. Dans le produit final, la couche semi-conductrice est recouverte par une couche de passivation, ouverte au-dessus de chaque jonction PN pour laisser passer un connecteur métallique. Les résidus de la structure riche en cadmium peuvent avoir été retirés.

Les figures 5A et 5B illustrent des exemples de structures riches en cadmium, présentant des portions de différentes épaisseurs et même concentration initiale en cadmium.

On a représenté en particulier une vue en perspective d'un groupement de photodiodes tel que défini ci-avant. Les pixels 121 de la couche semi-conductrice sont délimités par des traits pointillés.

A la figure 5A, la structure riche en cadmium est constituée de plots 570A centrés chacun sur un pixel 121, en forme de cylindres de révolution de mêmes diamètres.

Par exemple, deux pixels 121 sont surmontés de plots respectifs d'épaisseur $e_1$, et un troisième pixel 121 est surmonté d'un plot d'épaisseur $e_2$. Un quatrième pixel n'est pas recouvert par un plot de la structure riche en cadmium.

Les plots sont centrés sur le centre des jonctions PN de chaque photodiode. Ils peuvent être de diamètre supérieur, inférieur ou égal à la largeur de la jonction PN.

Selon une variante non représentée, les structures riches en cadmium sont en forme de parallélépipèdes rectangles à base carré de différentes épaisseurs, et centrés sur le centre des jonctions PN de chaque photodiode.

Ce mode de réalisation, dans lequel la structure riche en cadmium est constituée de plots pleins, est particulièrement adapté à des matrices à faible pas de pixel.

La figure 5B illustre une variante dans laquelle les plots 570B sont ouverts au centre et espacés les uns des autres. Ils présentent chacun une forme de tube, c'est-à-dire de cylindre de révolution ouvert au centre, l'ouverture étant en forme de cylindre de révolution concentrique et de même hauteur.

Les tubes présentent les mêmes diamètres internes et externes, et des épaisseurs différentes.

Ils sont centrés sur le centre des jonctions PN de chaque photodiode. L'ouverture peut être de diamètre inférieur, supérieur ou égal au diamètre de chaque jonction PN, et même de diamètre supérieur au diamètre des zones de charge d'espace.

Selon une variante non représentée, les structures riches en cadmium sont en forme de parallélépipèdes rectangles à base carré ouverts au centre, l'ouverture étant également en forme de parallélépipèdes rectangles, de même épaisseur.

Ce mode de réalisation, dans lequel la structure riche en cadmium est constituée de plots ouverts au centre, permet également d'améliorer une fonction de transfert de modulation de la matrice de photodiodes. La largeur de ces tubes sera alors avantageusement inférieure à $2\mu m$.

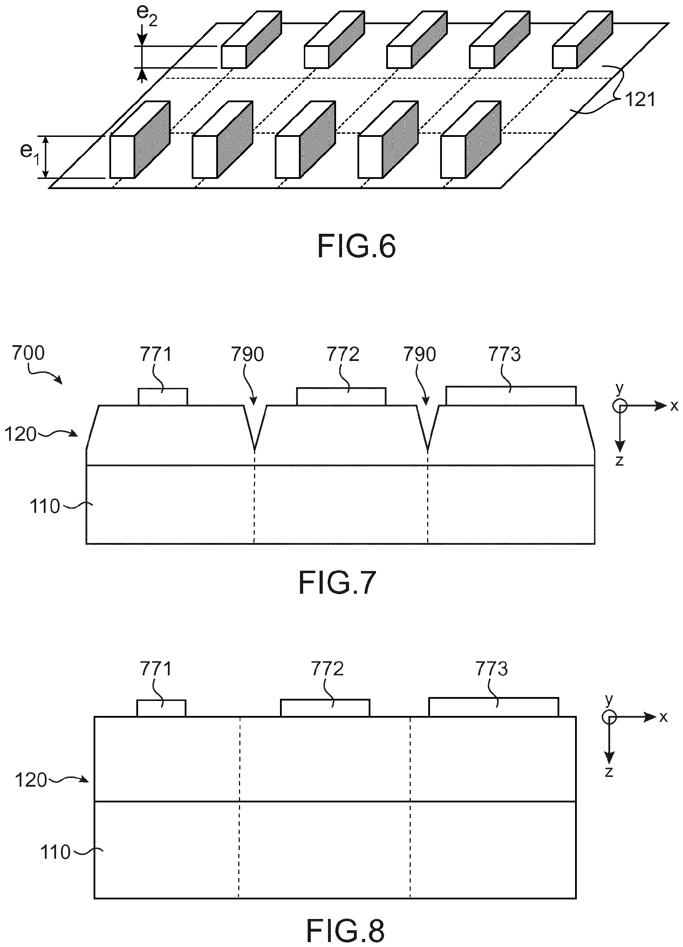

La figure 6 illustre un autre exemple de structure riche en cadmium mise en œuvre dans le procédé décrit ci-avant. Dans cet exemple, les portions de structure riche en cadmium, associées chacune à un pixel 121 de la couche semi-conductrice, ne sont pas centrées sur le pixel associées. Elles sont en outre formées d'un seul tenant deux à deux, centrées sur l'intersection entre deux pixels voisins. Elles présentent toutes la même concentration initiale en cadmium.

Le long de chaque ligne de pixels 121, chaque intersection entre deux plots voisins est surmontée par un plot de hauteur $e_1$, ou un plot de hauteur $e_2$, ou aucun plot.

La figure 6 illustre en particulier une variante selon laquelle, il y a deux géométries possibles pour les plots, et certains pixels de la couche semi-conductrice ne sont recouverts par aucune portion de la structure riche en cadmium.

De nombreuses autres formes peuvent être mises en œuvre sans sortir du cadre de la présente invention (épaisseur et géométrie variables selon les pixels).

La figure 7 illustre de manière schématique un deuxième mode de réalisation d'un procédé et d'une matrice de photodiodes 700 selon l'invention, qui ne sera décrit que pour ses différences relativement au premier mode de réalisation.

Dans l'exemple illustré en figure 7, la couche semi-conductrice 120 présente une structure mésa, comme illustré en figure 4.

Les portions 771, 772, 773 de la structure riche en cadmium présentent cette fois toutes la même épaisseur selon (Oz), mais différentes sections dans un plan orthogonal à l'axe (Oz) (et la même concentration initiale en cadmium).

Ce mode de réalisation est particulièrement avantageux, puisque grâce aux tranchées 790, le volume de diffusion associé à chaque portion 771, 772, 773 est sensiblement le même, comme dans le cas de la matrice de photodiodes 400. En effet, ces tranchées limitent la diffusion latérale du cadmium dans chaque pixel de la couche semi-conductrice. Un autre avantage de ce mode de réalisation est que les portions de structure riches en cadmium peuvent ici être déposées en une seule étape, sans avoir recours à des photolithographies et dépôts successifs comme dans le cas décrit précédemment. Ceci simplement la réalisation de la matrice de photodiodes multi-spectrale.

La figure 7 illustre plus particulièrement la matrice obtenue directement à l'issue du recuit d'inter-diffusion. Dans le produit final, la couche semi-conductrice est recouverte par une couche de passivation, ouverte au-dessus de chaque jonction PN pour laisser passer un connecteur métallique. Les résidus de la structure riche en cadmium peuvent avoir été retirés.

On peut combiner les modes de réalisation des figures 7 et 4, pour réaliser des portions de structure riche en cadmium présentant différentes épaisseurs et différentes sections, d'un pixel à l'autre de la couche semi-conductrice.

La figure 8 illustre de manière schématique une variante du procédé et de la matrice de photodiodes illustrés à la figure 7, dans lequel la matrice 800 ne présente pas une structure mésa mais une structure planaire.

L'homme du métier pourra également combiner les modes de réalisation des figures 8 et 1, pour réaliser des portions de structure riche en cadmium présentant différentes épaisseurs et différentes sections, d'un pixel à l'autre de la couche semi-conductrice.

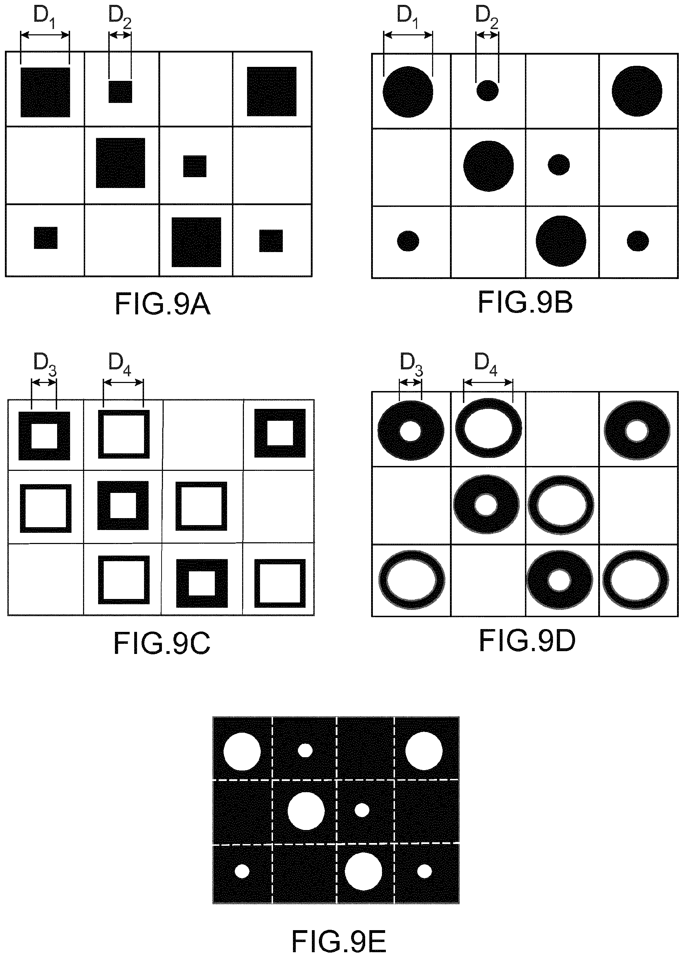

Les figures 9A à 9E illustrent différentes variantes d'une structure riche en cadmium selon l'invention, présentant des portions de différentes sections.

La figure 9A illustre, en vue de dessus, une série de douze photodiodes.

La structure riche en cadmium est constituée de plots (en noir). Chaque plot est un parallélépipède rectangle à base carré, centré sur une photodiode et plein au centre. Tous les plots présentent la même épaisseur. Tous les plots ne présentent pas la même section. Un premier type de plot présente une base carré de côté $D_1$, et un second type de plot présente une base carré de côté $D_2 < D_1$. Certaines photodiodes ne sont pas surmontées par une portion de structure riche en cadmium.

Les plots présentent un agencement périodique, avec un motif périodique s'étendant sur une surface carré de trois photodiodes par trois photodiodes.

La figure 9B ne diffère de la figure 9A qu'en ce que les plots présentent des formes de cylindres de révolution de diamètres $D_1$ ou $D_2 < D_1$.

Les modes de réalisation des figures 9A et 9B sont particulièrement avantageux pour de faibles pas de pixel de la matrice de photodiodes.

La figure 9C ne diffère de la figure 9A qu'en ce que les plots présentent tous les mêmes dimensions externes, et sont traversés au centre par une ouverture traversante. (Le motif de répartition des plots diffère également très légèrement.) Chaque plot présente une section dans un plan orthogonal à (Oz) en forme de carré à bords larges. Tous les plots présentent des dimensions externes définies par un parallélépipède rectangle à base carré de côté $D_1$. Un premier type de plot présente une ouverture traversante en forme de parallélépipède rectangle à base carré de côté $D_3$. Un second type de plot présente une ouverture traversante en forme de parallélépipède rectangle à base carré de côté $D_4 > D_3$.

La figure 9D ne diffère de la figure 9C qu'en ce que les plots et les ouvertures traversantes sont chacun en forme de cylindre de révolution centré sur une photodiode. (Le motif de répartition des plots correspond à celui de la figure 9D).

Les modes de réalisation des figures 9C et 9D permettent de réaliser une matrice de photodiodes à FTM améliorée. Les largeurs de ces tubes seront alors avantageusement inférieures à $2\mu m$.

Dans une autre variante illustrée en figure 9E, la structure riche en cadmium est constituée de trois types de plots associés chacun à une photodiode. Chaque plot présente des dimensions externes qui correspondent à celles de la face supérieure d'une photodiode. Un premier type de plot est plein au centre. Un deuxième type de plot est traversé par une ouverture traversante cylindrique centrée sur une photodiode et de premier diamètre. Un troisième type de plot est traversé par une ouverture traversante cylindrique centrée sur une photodiode et de second diamètre. Tous les plots sont formés d'un seul tenant de façon à constituer une grille.

De nombreuses autres formes peuvent être mises en œuvre sans sortir du cadre de la présente invention.

On a décrit ci-avant un procédé comprenant un unique cycle de :

- dépôt de matériau riche en cadmium, pour former une structure riche en cadmium sur la couche semi-conductrice ; et
- recuit d'inter-diffusion.

En variante, le procédé peut comprendre plusieurs cycles de dépôt de matériau riche en cadmium et recuit d'inter-diffusion.

Les plusieurs étapes de dépôt de matériau riche en cadmium définissent ensemble une étape de réalisation d'une structure riche en cadmium selon l'invention.

Les plusieurs étapes de recuit d'inter-diffusion sont nommées alors recuits partiels. On peut considérer que ces recuits partiels définissent ensemble un unique recuit d'inter-diffusion dit fractionné, à l'issue duquel tous les pixels de la couche semi-conductrice ne présentent pas la même longueur d'onde de coupure. En d'autres termes, les recuits partiels sont adaptés de sorte qu'à l'issue de ces recuits partiels, tous les pixels de la couche semi-conductrice ne présentent pas la même longueur d'onde de coupure.

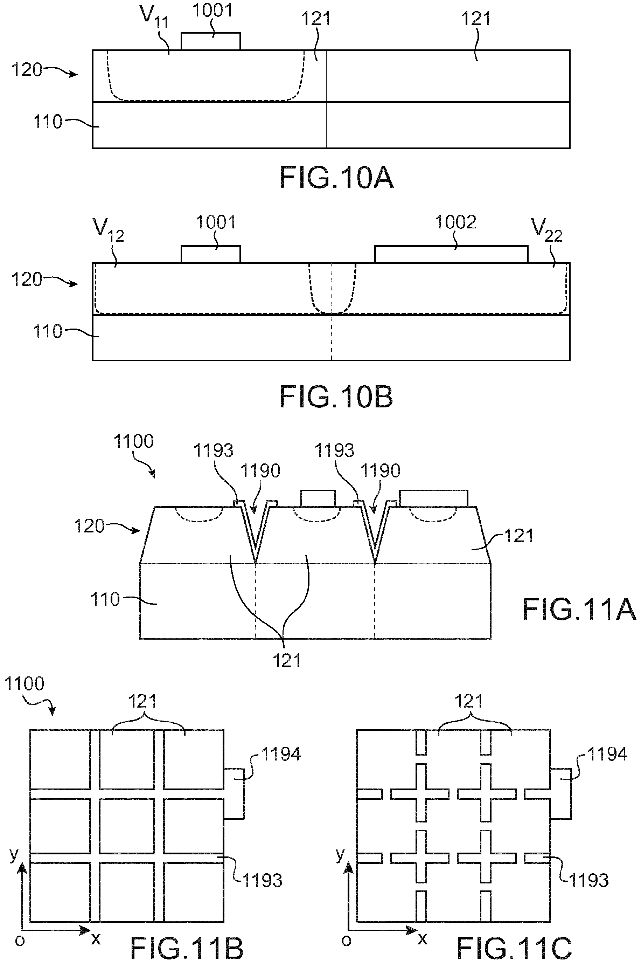

Les figures 10A et 10B illustrent de façon schématique un troisième mode de réalisation de procédé selon l'invention, correspondant à cette variante de l'invention.

Dans ce mode de réalisation, on réalise successivement des étapes de dépôt matériau riche en cadmium et recuit d'inter-diffusion, dit recuit partiel.

L'ensemble des recuits partiels forme le recuit d'inter-diffusion selon l'invention. L'ensemble des dépôts de matériau riche en cadmium forme la réalisation d'une structure riche en cadmium selon l'invention.

Chaque dépôt de matériau riche en cadmium peut comprendre le dépôt de plots de mêmes épaisseurs, déposées à des endroits différents sur la couche semi-conductrice avant chaque recuit partiel. Le résidu des plots peut être retiré, ou conservé après un recuit partiel. Ainsi, un plot peut être superposé, entièrement ou partiellement, sur un plot ayant été précédemment déposé et recuit. Les plots de mêmes épaisseurs peuvent présenter différentes sections, ou les mêmes sections.

Le volume de diffusion à l'issue de chaque recuit partiel peut être inférieur ou égal ou volume du pixel.

En fin de réalisation, selon le nombre de recuit(s) partiel(s) et de plot(s) riche(s) en cadmium qu'aura vu un pixel, sa concentration minimale en cadmium sera plus ou moins grande.

Ce mode de réalisation est particulièrement avantageux avec une couche semi-conductrice planaire.

Cependant, de façon avantageuse, un seul dépôt de structure riche cadmium sera effectué de façon à simplifier le procédé de fabrication.

Les figures 10A et 10B illustrent un exemple de procédé comprenant plusieurs recuits d'inter-diffusion partiels pour contrôler la quantité totale de cadmium rentrant dans les pixels 121 d'une structure planaire.

Au cours d'un premier cycle (figure 10A), on réalise un premier dépôt de matériau riche en cadmium. On dépose le plot 1001 centré le pixel 121, à gauche sur la figure. La face supérieure du pixel à droite sur la figure est laissée libre. On réalise un premier recuit partiel. A l'issue de ce premier recuit, les atomes de cadmium du plot 1001 ont diffusé dans un volume de diffusion intermédiaire $V_{11}$.

Au cours d'un second cycle (figure 10B), on ajoute un plot 1002 au-dessus du pixel 121 à droite sur la figure. Le plot 1002 présente une section bien plus large que le plot 1001. On réalise un second recuit partiel. A l'issue de ce second recuit, les atomes de cadmium du plot 1001 ont continué à diffuser dans le pixel de gauche, pour s'étendre finalement dans le volume de diffusion total $V_{12}$, et les atomes de cadmium du plot 1002 ont diffusé dans le volume de diffusion total $V_{22}$. Les volumes $V_{12}$ et $V_{22}$ sont sensiblement égaux entre eux, et sensiblement égaux au volume d'un pixel de la couche semi-conductrice.

Le premier recuit partiel et le second recuit partiel forment ensemble un recuit d'inter-diffusion tel que décrit précédemment, fractionné ici en deux recuits partiels, à l'issue duquel le pixel de gauche et le pixel de droite sur les figures 10A et 10B ne présentent pas la même longueur d'onde de coupure.

Ce mode de réalisation permet notamment d'obtenir des volumes de diffusion sensiblement égaux pour chaque pixel, malgré des plots riches en cadmium dont la section peut différer fortement d'un pixel à l'autre.

En variante, on peut mettre en œuvre des dépôts successifs de matériaux plus ou moins riches initialement en cadmium, suivi de recuit(s) d'inter-diffusion que l'homme de métier saura adapter pour obtenir des longueurs d'onde de coupure différentes d'un pixel à un pixel, ces pixels étant de préférence répartis de façon périodique à l'échelle de la matrice comme décrit précédemment.

Quel que soit le mode de réalisation, la couche semi-conductrice 120 est de préférence très fine, par exemple inférieure à la longueur de diffusion des porteurs minoritaires dans celle-ci. Le recuit d'inter-diffusion est adapté en conséquence. Une épaisseur réduite permet d'améliorer la FTM puisque la probabilité qu'un photoporteur diffuse dans le pixel voisin est réduite. En outre, le courant d'obscurité est encore réduit. Dans le cas particulier d'une structure mésa, les tranchées à graver sont moins profondes et donc plus faciles à réaliser; ainsi le courant d'obscurité sera potentiellement moins dégradé que pour une gravure plus profonde. Enfin, une couche semi-conductrice de faible épaisseur permet d'obtenir de plus grandes variations de la longueur d'onde de coupure au sein d'une même matrice.

Les figures 11A et 11B illustrent de manière schématique une variante des procédés et matrices de photodiodes illustrées aux figures 4 et 7.

Selon cette variante, la matrice 1100 présente une structure mésa, dans laquelle les tranchées 1190 séparant les photodiodes s'étendent sur toute l'épaisseur de la couche semi-conductrice 120, jusqu'au substrat 110.

La matrice présente alors une excellente FTM. En outre, le volume de diffusion du cadmium de chaque portion de structure riche en cadmium est limité au pixel situé en-dessous. On peut ainsi utiliser des recuits plus longs et/ou à température plus élevée, permettant d'obtenir dans chaque pixel une concentration homogène en cadmium et distinct de la concentration en cadmium d'un pixel voisin. Enfin, on peut obtenir plus facilement de plus grandes variations de la longueur d'onde de coupure au sein d'une même matrice.

La figure 11A représente une vue en coupe de ladite matrice. La figure 11B représente une vue de dessus.

Afin de rétablir un contact électrique entre les semelles de chaque photodiodes, et d'avoir une continuité électrique entre elles, on réalise des métallisations 1193 dans les tranchées. Chaque métallisation est constituée d'une fine couche de métal, électriquement conducteur, recouvrant le fond des tranchées. Dans l'exemple représenté sur les figures, les métallisations s'étendent sur l'intégralité des faces internes de ces tranchées, et dépassent légèrement sur la face supérieure de la couche semi-conductrice 120, parallèle au plan (xOy). Les métallisations forment ensemble un maillage continu s'étendant entre les photodiodes, et relié à une électrode 1194 déportée en périphérie de la matrice.

Dans ce mode de réalisation, la zone de charge d'espace entourant les jonctions PN doit être située à distance des bords des métallisations, pour éviter un court-circuit.

Une variante à ce mode de réalisation consiste à supprimer la continuité de ce maillage métallique de manière à relaxer les éventuelles contraintes mécaniques induites par le dépôt d'une couche métallique (figure 11C), tout en assurant une résistance série faible à l'échelle de la matrice. En pratique, on découpe sur toute la largeur d'une ligne métallique un tout petit rectangle, pour former une ouverture de l'ordre du micron par exemple (exagérée en figure 11C par souci d'illustration). Ceci sera particulièrement avantageux pour les grands formats de matrices de photodiodes.

Enfin une dernière variante de ce mode de réalisation consiste s'affranchir des métallisations dans les tranchées, et à utiliser plutôt un dopage substrat plus fort localement (n+ ou p+ selon type de jonction, obtenu par exemple par implantation) pour assurer une résistance série faible à l'échelle de la matrice. La métallisation de reprise du contact substrat s'étend alors uniquement en périphérie de la matrice. Cette variante permet la réalisation de matrice de photodiodes à de très petits pas pixel (<15 $\mu$m) pour lesquels il serait difficile de déposer une métallisation dans les tranchées.

## Revendications

1. Procédé pour fabriquer une matrice (300 ; 400 ; 700 ; 800 ; 1100) de photodiodes multi-spectrale dans une couche semi-conductrice (120) en $Cd_xHg_{1-x}Te$ constituée de régions juxtaposées dites pixels (121), le procédé comprenant une étape de réalisation d'une jonction PN dans chaque pixel, **caractérisé en ce qu'**il comprend les étapes suivantes, mises en œuvre au moins une fois :

   - dépôt (101) de matériau riche en cadmium (170 ; 1001 ; 1002) sur la couche semi-conductrice en $Cd_xHg_{1-x}Te$, pour réaliser une structure riche en cadmium (170), le matériau riche en cadmium (170 ; 1001; 1002) présentant une concentration en cadmium supérieure à celle de la couche semi-conductrice (120) ; puis
   - recuit d'inter-diffusion (102), réalisant la diffusion des atomes de cadmium depuis le matériau riche en cadmium (170) vers la couche semi-conductrice (120) ;

   la structure riche en cadmium étant constituée de portions surmontant chacune un pixel (121), la structure en cadmium présentant au moins deux types de portions qui diffèrent par leurs volumes et/ou concentrations initiales, ou toutes les portions étant identiques et certains pixels (121) n'étant recouverts par aucune desdites portions ; et l'au moins un recuit d'inter-diffusion étant adapté pour qu'à l'issue de cet au moins un recuit, tous les pixels (121) ne présentent pas la même longueur d'onde de coupure.

2. Procédé selon la revendication 1, **caractérisé en ce que** la structure riche (170) en cadmium est constituée de portions (171 ; 172 ; 173 ; 570A ; 570B, 771 ; 772 ; 773 ; 1001 ; 1002), centrées chacune sur un pixel (121) de la couche semi-conductrice.

3. Procédé selon la revendication 2, **caractérisé en ce que** chaque portion (171 ; 172 ; 173 ; 570A ; 771 ; 772 ; 773 ; 1001 ; 1002) présente une forme de plot, plein au centre et espacé des autres plots.

4. Procédé selon la revendication 2, **caractérisé en ce que** chaque portion présente une forme de plot (570B), ouvert au centre et espacé des autres plots.

5. Procédé selon la revendication 2, **caractérisé en ce que** les différentes portions forment ensemble une grille présentant des ouvertures centrées chacune sur un pixel.

6. Procédé selon la revendication 1, **caractérisé en ce que** la structure riche en cadmium est constituée de portions surmontant chacune un pixel (121) de la couche semi-conductrice, chaque portion étant décentrée relativement au pixel correspondant et plusieurs portions étant formées d'un seul tenant.

7. Procédé selon l'une quelconque des revendications 1 à 6, **caractérisé en ce que** la structure riche en cadmium présente des portions (171 ; 172 ; 173 ; 570A ; 570B) de différentes épaisseurs.

8. Procédé selon l'une quelconque des revendications 1 à 7, **caractérisé en ce que** la structure riche en cadmium présente des portions (771 ; 772 ; 773 ; 1001 ; 1002) de différentes sections.

9. Procédé selon l'une quelconque des revendications 1 à 8, **caractérisé en ce que** la structure riche en cadmium présente des portions de différentes concentrations initiales.

10. Procédé selon l'une quelconque des revendications 1 à 9, **caractérisé en ce que** la structure riche en cadmium (170) est constituée de portions surmontant chacune un pixel de la couche semi-conductrice, et comprend au moins deux types de portions (171 ; 172 ; 173 ; 570A ; 570B ; 771 ; 772 ; 773 ; 1001 ; 1002) qui diffèrent par leurs sections, épaisseurs et/ou concentrations initiales.

11. Procédé selon l'une quelconque des revendications 1 à 10, **caractérisé en ce que** la structure riche en cadmium (170) est périodique, et **en ce qu'**un motif élémentaire de la structure périodique (170) s'étend au-dessus d'une pluralité de pixels (121) de la couche semi-conductrice.

12. Procédé selon l'une quelconque des revendications 1 à 11, **caractérisé en ce qu'**il comprend plusieurs cycles des étapes de dépôt de matériau riche en cadmium sur la couche semi-conductrice, puis recuit d'inter-diffusion.

13. Procédé selon l'une quelconque des revendications 1 à 12, **caractérisé en ce que** la couche semi-conductrice (120) présente une structure mésa dans laquelle des tranchées (1190) séparant des photodiodes voisines s'étendent sur toute la hauteur de ladite couche semi-conductrice, et **en ce qu'**il comprend en outre une métallisation (1190) de ces tranchées, réalisant une jonction électrique entre les photodiodes.

14. Procédé selon l'une quelconque des revendications 1 à 12, **caractérisé en ce que** la couche semi-conductrice (120) présente une structure mésa dans laquelle des tranchées (490, 790) séparant des photodiodes voisines ne s'étendent pas sur toute la hauteur de ladite couche semi-conductrice, de façon à préserver la continuité électrique entre les photodiodes.

## Patentansprüche

1. Verfahren zur Herstellung einer Multispektralphotodiodenmatrix (300; 400; 700; 800; 1100) in einer Halbleiterschicht (120) aus $Cd_xHg_{1-x}Te$, die aus nebeneinanderliegenden Bereichen, Pixel (121) genannt, besteht, wobei das Verfahren einen Schritt der Herstellung eines PN-Übergangs in jedem Pixel umfasst, **dadurch gekennzeichnet, dass** es die folgenden Schritte umfasst, die mindestens einmal ausgeführt werden:

- Abscheiden (101) von cadmiumreichem Material (170; 1001; 1002) auf der Halbleiterschicht aus $Cd_xHg_{1-x}Te$, um eine cadmiumreiche Struktur (170) zu erzeugen, wobei das cadmiumreiche Material (170; 1001; 1002) eine höhere Cadmiumkonzentration als die Halbleiterschicht (120) aufweist; dann
- Interdiffusionsglühen (102), bei dem die Diffusion von Cadmiumatomen aus dem cadmiumreichen Material (170) in die Halbleiterschicht (120) erfolgt;

wobei die cadmiumreiche Struktur aus Abschnitten besteht, die jeweils oberhalb einem Pixel (121) liegen,
wobei die cadmiumreiche Struktur zumindest zwei Arten von Abschnitten aufweist, die sich in ihren Volumina und/oder anfänglichen Konzentrationen unterscheiden, oder wobei alle Abschnitte identisch sind und einige Pixel (121) von keinem der Abschnitte bedeckt sind; und
wobei das zumindest eine Interdiffusionsglühen dazu ausgelegt ist, dass nach diesem zumindest einen Glühen nicht alle Pixel (121) die gleiche Grenzwellenlänge haben.

2. Verfahren nach Anspruch 1, **dadurch gekennzeichnet, dass** die cadmiumreiche Struktur (170) aus Abschnitten (171; 172; 173; 570A; 570B; 771; 772; 773; 1001; 1002) besteht, die jeweils auf ein Pixel (121) der Halbleiterschicht zentriert sind.

3. Verfahren nach Anspruch 2, **dadurch gekennzeichnet, dass** jeder Abschnitt (171; 172; 173; 570A; 771; 772; 773; 1001; 1002) die Form eines Pads aufweist, das in der Mitte massiv ausgeführt ist und von den anderen Pads beabstandet ist.

4. Verfahren nach Anspruch 2, **dadurch gekennzeichnet, dass** jeder Abschnitt die Form eines Pads (570B) aufweist, das in der Mitte offen ist und von den anderen Pads beabstandet ist.

5. Verfahren nach Anspruch 2, **dadurch gekennzeichnet, dass** die verschiedenen Abschnitte zusammen ein Gitter mit Öffnungen aufweisen, die jeweils auf ein Pixel zentriert sind.

6. Verfahren nach Anspruch 1, **dadurch gekennzeichnet, dass** die cadmiumreiche Struktur aus Abschnitten besteht, die jeweils oberhalb einem Pixel (121) der Halbleiterschicht liegen, wobei jeder Abschnitt bezüglich des entsprechenden Pixels dezentriert ist und mehrere Abschnitte aus einem Stück gebildet sind.

7. Verfahren nach einem der Ansprüche 1 bis 6, **dadurch gekennzeichnet, dass** die cadmiumreiche Struktur Abschnitte (171; 172; 173; 570A; 570B) mit unterschiedlichen Dicken aufweist.

8. Verfahren nach einem der Ansprüche 1 bis 7, **dadurch gekennzeichnet, dass** die cadmiumreiche Struktur Abschnitte (771; 772; 773; 1001; 1002) mit unterschiedlichen Querschnitten aufweist.

**9.** Verfahren nach einem der Ansprüche 1 bis 8, **dadurch gekennzeichnet, dass** die cadmiumreiche Struktur Abschnitte mit unterschiedlichen anfänglichen Konzentrationen aufweist.

**10.** Verfahren nach einem der Ansprüche 1 bis 9, **dadurch gekennzeichnet, dass** die cadmiumreiche Struktur (170) aus Abschnitten besteht, die jeweils oberhalb einem Pixel der Halbleiterschicht liegen, und zumindest zwei Arten von Abschnitten (171; 172; 173; 570A; 570B; 771; 772; 773; 1001; 1002) aufweist, die sich in ihren Querschnitten, Dicken und/oder anfänglichen Konzentrationen unterscheiden.

**11.** Verfahren nach einem der Ansprüche 1 bis 10, **dadurch gekennzeichnet, dass** die cadmiumreiche Struktur (170) periodisch ist und dass ein Elementarmuster der periodischen Struktur (170) sich über einer Vielzahl von Pixeln (121) der Halbleiterschicht erstreckt.

**12.** Verfahren nach einem der Ansprüche 1 bis 11, **dadurch gekennzeichnet, dass** es mehrere Zyklen der Schritte des Abscheidens von cadmiumreichem Material auf der Halbleiterschicht und des anschließenden Interdiffusionsglühens umfasst.

**13.** Verfahren nach einem der Ansprüche 1 bis 12, **dadurch gekennzeichnet, dass** die Halbleiterschicht (120) eine Mesa-Struktur aufweist, in der Gräben (1190), die benachbarte Photodioden trennen, sich über die gesamte Höhe der Halbleiterschicht erstrecken, und dass es ferner eine Metallisierung (1190) dieser Gräben umfasst, wodurch ein elektrischer Übergang zwischen den Photodioden geschaffen wird.

**14.** Verfahren nach einem der Ansprüche 1 bis 12, **dadurch gekennzeichnet, dass** die Halbleiterschicht (120) eine Mesa-Struktur aufweist, in der Gräben (490, 790), die benachbarte Photodioden trennen, sich nicht über die gesamte Höhe der Halbleiterschicht erstrecken, so dass die elektrische Kontinuität zwischen den Photodioden erhalten bleibt.

**Claims**

**1.** A method for manufacturing a multispectral photodiode array (300; 400; 700; 800; 1100) in a $Cd_xHg_{1-x}Te$ semi-conducting layer (120) consisting of juxtaposed regions called pixels (121), the method comprising a step of making a PN junction in each pixel, **characterised in that** it comprises the following steps, implemented at least once:

- depositing (101) cadmium-rich material (170; 1001; 1002) on the $Cd_xHg_{1-x}Te$ semi-conducting layer, to make a cadmium-rich structure (170), the cadmium-rich material (170; 1001; 1002) having a cadmium concentration greater than that of the semi-conducting layer (120); and then
- inter-diffusion annealing (102), performing diffusion of cadmium atoms from the cadmium-rich material (170) to the semi-conducting layer (120);

the cadmium-rich structure consisting of portions each on top of a pixel (121), the cadmium structure having at least two types of portions which differ in their volumes and/or initial concentrations, or all the portions being identical and some pixels (121) being covered by none of said portions; and the at least one inter-diffusion annealing being adapted so that at the end of this at least one annealing, all the pixels (121) do not have the same cut-off wavelength.

**2.** The method according to claim 1, **characterised in that** the cadmium-rich structure (170) consists of portions (171; 172; 173; 570A; 570B, 771; 772; 773; 1001; 1002), each centred on a pixel (121) of the semi-conducting layer.

**3.** The method according to claim 2, **characterised in that** each portion (171; 172; 173; 570A; 771; 772; 773; 1001; 1002) has a stud shape, solid in the centre and spaced apart from the other studs.

**4.** The method according to claim 2, **characterised in that** each portion has a stud (570B) shape, open in the centre and spaced apart from the other studs.

**5.** The method according to claim 2, **characterised in that** the different portions form together a gate having apertures each centred on a pixel.

**6.** The method according to claim 1, **characterised in that** the cadmium-rich structure consists of portions each on top of a pixel (121) of the semi-conducting layer, each portion being off-centred relative to the corresponding pixel and several portions being formed integrally.

**7.** The method according to any of claims 1 to 6, **characterised in that** the cadmium-rich structure has portions (171; 172; 173; 570A; 570B) of different thicknesses.

**8.** The method according to any of claims 1 to 7, **characterised in that** the cadmium-rich structure has portions (771; 772; 773; 1001; 1002) with different cross-sections.

9. The method according to any of claims 1 to 8, **characterised in that** the cadmium-rich structure has portions with different initial concentrations.

10. The method according to any of claims 1 to 9, **characterised in that** the cadmium-rich structure (170) consists of portions each on top of a pixel of the semi-conducting layer, and comprises at least two types of portions (171; 172; 173; 570A; 570B; 771; 772; 773; 1001; 1002) which differ in their cross-sections, thicknesses and/or initial concentrations.

11. The method according to any of claims 1 to 10, **characterised in that** the cadmium-rich structure (170) is periodic, and **in that** a unit cell of the periodic structure (170) extends above a plurality of pixels (121) of the semi-conducting layer.

12. The method according to any of claims 1 to 11, **characterised in that** it comprises several cycles of the steps of depositing cadmium-rich material on the semi-conducting layer and then inter-diffusion annealing.

13. The method according to any of claims 1 to 12, **characterised in that** the semi-conducting layer (120) has a mesa structure in which trenches (1190) separating neighbour photodiodes extend over the whole height of said semi-conducting layer, and **in that** it further comprises a metallisation (1190) of these trenches, making an electric junction between the photodiodes.

14. The method according to any of claims 1 to 12, **characterised in that** the semi-conducting layer (120) has a mesa structure in which trenches (490, 790) separating neighbour photodiodes do not extend over the whole height of said semi-conducting layer, so as to keep electrical continuity between the photodiodes.

FIG. 1

FIG. 2

FIG.3

FIG.4

FIG.5A

FIG.5B

FIG.6

FIG.7

FIG.8

FIG.9A

FIG.9B

FIG.9C

FIG.9D

FIG.9E

FIG.10A

FIG.10B

FIG.11A

FIG.11B

FIG.11C

**EP 3 157 067 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2432033 A2
- US 2014319580 A
- US 5861626 A
- US 3638026 A
- US 5880510 A
- US 2014346539 A
- EP 0069453 A
- EP 2975643 A
- EP 2937902 A